Europäisches Patentamt

(19) European Patent Office

Office européen des brevets

(11) Numéro de publication: **0 128 612**
B1

(12) **FASCICULE DE BREVET EUROPEEN**

(45) Date de publication du fascicule du brevet:
07.01.87

(51) Int. Cl.⁴: **H 03 H 11/48,** H 03 L 1/02

(21) Numéro de dépôt: **84200761.9**

(22) Date de dépôt: **25.05.84**

(54) **Circuit formant une capacité variable en fonction de la température et oscillateur hyperfréquences stabilisé en fréquence en fonction de la température à l'aide d'un tel circuit.**

(30) Priorité: **01.06.83 FR 8309071**

(43) Date de publication de la demande:
**19.12.84 Bulletin 84/51**

(45) Mention de la délivrance du brevet:
**07.01.87 Bulletin 87/2**

(84) Etats contractants désignés:
**DE FR GB IT**

(56) Documents cités:
**DE - A - 2 803 846**
**FR - A - 2 241 778**
**GB - A - 1 020 080**
**US - A - 4 333 062**

**ELECTRONICS LETTERS, vol. 18, no. 8, 15 avril 1982, pages 345-347, Londres, GB; C. TSIRONIS et al.: "Stable monolithic GaAs FET oscillator"**

(73) Titulaire: **Laboratoires d'Electronique et de Physique Appliquée L.E.P., 3, Avenue Descartes, F-94450 Limeil-Brévannes (FR)**
(84) Etats contractants désignés: **FR**

(73) Titulaire: **N.V. Philips' Gloeilampenfabrieken, Groenewoudseweg 1, NL-5621 BA Eindhoven (NL)**
(84) Etats contractants désignés: **DE GB IT**

(72) Inventeur: **Tsironis, Christos, Société Civile S.P.I.D. 209 rue de l'Université, F-75007 Paris (FR)**

(74) Mandataire: **Landousy, Christian et al, Société Civile S.P.I.D. 209, Rue de l'Université, F-75007 Paris (FR)**

## Description

L'invention concerne un circuit formant une capacité linéairement variable en fonction de la température.

L'invention concerne également un oscillateur hyperfréquences stabilisé en fréquence en fonction de la température, comprenant un transistor à effet de champ de type Schottky sur la grille duquel est appliqué un circuit destiné à déterminer la fréquence d'oscillation incluant cette capacité variable en fonction de la température.

L'invention trouve son application dans la réalisation de têtes de réception pour émissions de télévision transmises par satellites artificiels à la fréquence de 12 GHz.

Dans le cadre de cette application, il doit être réalisé un oscillateur local dont la mise au point pose différents problèmes techniques.

En premier lieu la fréquence fournie en sortie de l'oscillateur doit être à la fois très élevée (12 GHz) et très stable.

En second lieu le circuit oscillant doit être de réalisation aisée et d'un coût réduit puisqu'il est destiné à être fabriqué en grande série du fait qu'il touche au domaine de la télévision.

La résolution de ces problèmes passe donc, dans l'état actuel de la technique, par la réalisation d'un oscillateur hyper-fréquences, stabilisé en fréquence en fonction de la température, monolithiquement intégrale sur un substrat tel que l'arséniure de gallium, matériau qui, présentant une grande mobilité electronique, se prête de ce fait le mieux à ce jour aux applications hyperfréquences.

Un circuit oscillateur hyperfréquences et connu par le brevet des Etats-Unis n° 4 333 062 du 1er juin 1982, déposé sous priorité en date du 27 décembre 1979 par la Société MATSUSHITA Electric Industrial Co (Japan). Ce document décrit un oscillateur comprenant un transistor à effet de champ, stabilisé en fréquence par le moyen de deux résonateurs microrubans présentant une capacité insérée en leur milieu. Ces capacités varient linéairement en fonction de la température. L'un de ces résonateurs microruban opère comme un filtre de réjection de bande et un circuit de charge de l'oscillateur. L'autre résonateur microruban opère comme un résonateur série entre une porte de l'oscillateur et la masse.

Mais, ce dispositif, proposé pour les compensations de la fréquence d'oscillation en fonction de la température à une fréquence de 2,2 Ghz, n'est absolument pas intégrable d'une façon monolithique car les capacités utilisées sont obligatoirement en diélectrique.

En effet, le circuit proposé par le document cité est réalisé en technologie dite «hybride». Et cette technologie n'est pas transportable purement et simplement en technologie de circuits intégrés sur arséniure de gallium, car ces deux technologies sont conçues à partir de théories différentes. La technologie hybride fait appel à la théorie des lignes et comprend essentiellement des lignes 1/4 ondes ou 1/2 ondes qui, à la fréquence de 12 GHz atteignent facilement 25 mm. Des éléments d'une telle dimension ne peuvent être incorporés dans un circuit intégré sur arséniure de gallium GaAs. La technologie des circuits intégrés sur un tel matériau ne fait donc appel qu'à des éléments dits localisés, de quelques dizaines ou au plus quelques centaines de μm. Cependant, il serait éventuellement possible de réaliser des capacités intégrées sur un substrat en GaAs. Mais ces capacités, du type «interdigité», ne présentent pas de variations linéaires en fonction de la température.

Or, nous rappelons que le problème posé est double. Premièrement réaliser la compensation en température de l'oscillateur à 12 GHz et deuxièmement intégrer ce circuit de compensation sur le même substrat et avec la même technologie que ceux employés pour réaliser l'oscillateur.

C'est pourquoi la présente invention propose en premier lieu un circuit formant une capacité linéairement variable en fonction de la température remarquable en ce que cette capacité est formée par la capacité $C_v$ électrode d'entrée-canal d'un élément actif du type à diode Schottky dit élément actif de compensation dont l'électrode de sortie, ou les électrodes de sortie court-circuitées, est/sont soumise(s) à une tension de commande $V_v$ variable en fonction de la température, cette tension de commande $V_v$ étant fixée d'une part par rapport à la masse au travers d'une première résistance $R_1$ et d'autre part par rapport à l'alimentation continue $V_c$ au travers de N éléments actifs de type Schottky montés en diodes et en série, dont la première électrode d'entrée est connectée à l'alimentation continue $V_c$ à travers une seconde résistance $R_2$, et dont la dernière électrode de sortie est connectée à la sortie de l'élément actif de compensation, le nombre N d'éléments actifs étant choisi en tenant compte du fait que la tension de seuil des éléments actifs de type Schottky diminuant linéairement lorsque la température augmente, alors la tension $V_v$ appliquée à la sortie de l'élément actif de compensation augmente linéairement lorsque la température augmente et proportionnellement au nombre N, permettant de ce fait une augmentation linéaire de la capacité $C_v$ électrode d'entrée-canal de cet élément de compensation.

Dans ces conditions, le circuit, formant une capacité qui varie linéairement en fonction de la température, peut être réalisé sur un substrat en arséniure de gallium par exemple à l'aide de transistors à effet de champ ou de diodes de type Schottky, et peut être inclu dans le circuit d'ajustage de la fréquence d'un oscillateur hyperfréquences.

C'est pourquoi la présente invention propose en second lieu un oscillateur hyperfréquences tel que défini dans le préambule remarquable en ce que le circuit destiné à déterminer la fréquence d'oscillation est constitué d'une première self $L_1$ reliée d'une part à la masse et d'autre part à la grille du transistor oscillant, et d'une seconde self $L_2$ reliée d'une part à la grille du transistor oscillant et d'autre part à l'électrode d'entrée de l'élément actif de compensation du circuit formant une capacité à variations linéaires en fonction de la température selon l'invention.

Dans ces conditions la capacité variable de l'élément actif de compensation permet de compenser la variation de phase du transistor oscillant lorsque la température varie.

Selon une réalisation de l'invention, l'oscillateur hyperfréquences ainsi stabilisé en fréquence en fonction de la température est constitué d'éléments actifs de type Schottky et d'éléments localisés tels des selfs, des résistances et des capacités et monolithiquement intégré sur un substrat en arséniure de gallium.

Selon une réalisation de l'invention l'élément actif de compensation est un transistor de type Schottky et selon une autre réalisation cet élément est une diode de type Schottky.

Selon une réalisation de l'invention les N éléments actifs sont des transistors de type Schottky et selon une autre réalisation ce sont des diodes de type Schottky.

Dans ces conditions, l'oscillateur ainsi réalisé fournit une fréquence élevée et stable, et le circuit obtenu est compétitif tant sur le plan technique que sur le plan commercial.

Les particularités de l'invention et les modes de raélisaîton conformes à l'invention apparaissent de façon plus précise dans la description suivante en regard des figures annexées.

La figure 1 montre un oscillateur hyperfréquences selon l'invention dont le circuit de stabilisation de la fréquence en fonction de la température est réalisé à l'aide de transistors à effet de champ de type Schottky.

La figure 2 montre un tel circuit de stabilisation de la fréquence en fonction de la température réalisé à l'aide de diodes de type Schottky.

La figure 3 montre la courbe de variation de la tension de commande $V_v$ de l'élément actif de compensation en fonction de la température T, pour un nombre donné N = 3 d'éléments actifs dans le circuit de compensation.

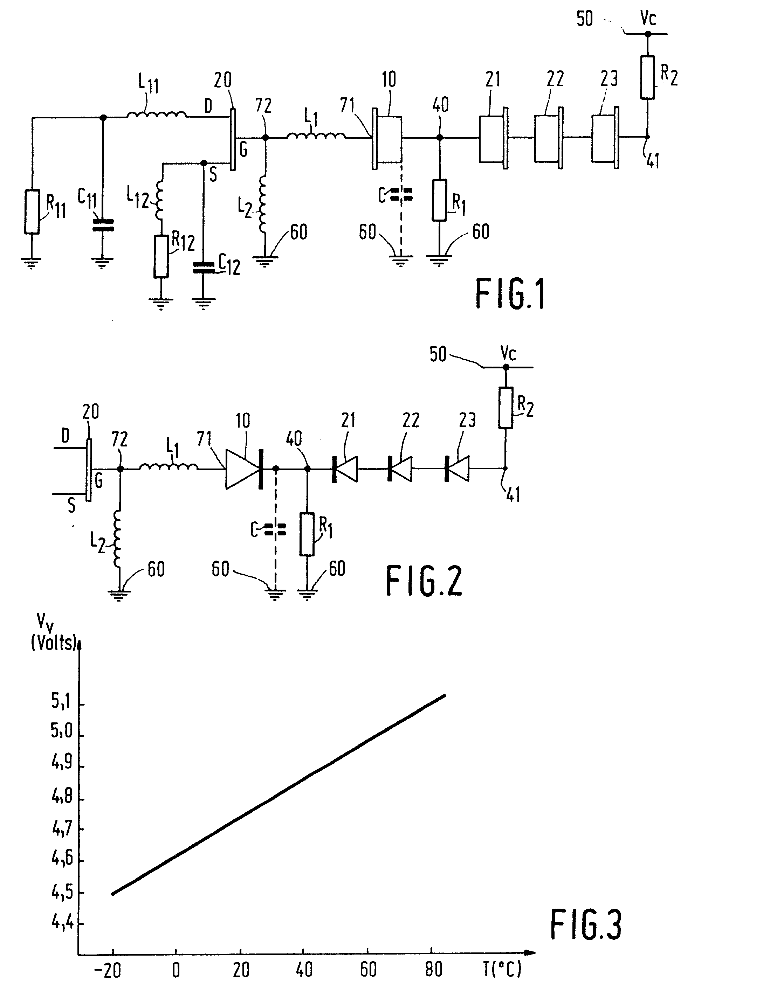

Le dispositif selon la figure 1 montre le transistor oscillant 20 dont la grille 72 est reliée d'une parte à la première self $L_1$ et d'autre part à la seconde self $L_2$ dont l'autre extrémité est réliée à la masse 60. La grille 71 du transistor à effet de champ (TEC) de compensation 10 est réliée à l'autre extrémité de la self $L_1$ tandis que le drain et la source du TEC 10 court-circuités et numérotés 40 sont reliés d'une part à une résistance $R_1$ dont l'autre extrémité est à la masse 60, et d'autre part à l'ensemble de 3 TEC, numérotés 21, 22 et 23 fonctionnant en diodes (drain et sources court-circuités) montés en série (connexion drain-source reliée à la grille du suivant), la première connexion drain-source du TEC 21 étant reliée au point 40 et la dernière grille du TEC 23 étant reliée à l'extrémité 41 d'une résistance $R_2$ dont l'autre extrémité est reliée à l'alimentation continue 50.

Les selfs $L_1$ et $L_2$ et la capacité grille-canal du TEC 10 constituent le circuit qui détermine la fréquence d'oscillation du transistor oscillant 20.

Le circuit constitué d'une self $L_{12}$ et d'une résistance $R_{12}$, ainsi que d'une capacité $C_{12}$ en parallèle avec $L_{12}$ et $R_{12}$ et monté entre la masse et la source du transistor oscillant 20 est destiné à entretenir les conditions d'oscillation.

Le circuit constitué d'une capacité $C_{11}$ et d'une self $L_{11}$, monté entre la masse et le drain du transistor oscillant 20 forme l'adaptation d'impédance qui permet d'otimiser la puissance de sortie de l'oscilla-teur, la résistance $R_{11}$ placée entre la masse et le point commun à $L_{11}$ et $C_{11}$ étant l'impédance de charge.

Un oscillateur dont les conditions d'oscillation et l'optimisation de la puissance de sortie sont réalisées sur la source et le drain par des circuits semblables est connu de l'art antérieur par la publication de C. TSIRONIS et alii dans Electronics Letters du 15 avril 1982 (Vol. 18, N° 8, pages 345-347).

On notera que la présente invention ne porte pas sur l'oscillateur lui-même, mais bien, sur le circuit formant une capacité variable linéairement en fonction de la température et sur l'association d'un tel circuit avec l'oscillateur hyperfréquence de manière à obtenir un oscillateur à la fois stabilisé en fréquence en fonction de la température et monolithiquement intégrable sur arséniure de gallium par exemple.

La figure 2 montre le même circuit dans lequel des diodes Schottky remplacent les TEC.

Le fonctionnemenr du circuit selon la figure 1 ou suivant la figure 2 est fondé sur le fait qu'il apparaît dans l'un ou l'autre en hyperfréquences, et seulement en hyperfréquences, une capacité de grande valeur C entre les électrodes de sortie 40 de l'élément actif 10 et la masse 60. En courant continu, le TEC 10 est isolé. La polarisation continue du canal du TEC 10 au point 40 est contrôlée par le réseau de TEC ou de diodes 21, 22, 23 de manière « faire varier cette capacité grille-canal d'une quantité voulue. Les résistances $R_1$ et $R_2$ servent à fixer ce point de polarisation à une valeur de référence pour une température donnée.

La tension de seuil des TEC ou des diodes 21, 22, 23 varie en fonction de la température en suivant une loi linéaire connue. Elle diminue linéairement de 2 mV/°C pour un courant constant et par élément Schottky.

Des mesures effectuées sur le dispositif présenté ici ont montré que la tension $V_v$ qu'il est nécessaire d'appliquer sur le canal du transistor 10, entre —20 et 80°C, varie en augmentant linéairement de 6 mV/°C comme il est montré sur le graphique de la figure 3 en trait plein.

Ce qui conduit à choisir le nombre N de TEC ou de diodes Schottky égal à 3 dans le réseau situé entre les points 40 et 41 des figures 1 ou 2.

La tension appliquée $V_v$ au point 40, variant linéairement en fonction de la température, permet donc d'obtenir une variation linéaire de la capacité grille-canal du transistor 10, ce qui fournit une compensation en fréquence de l'oscillateur excellente, pour une fréquence de 12 GHz, à des températures comprises entre —20 et +80°C.

Il est à noter que les TEC Schottky ou les diodes Schottky sont parfaitement intégrables sur un substrat en AsGa, de même que les résistances qui sont réalisées par implantation d'une couche résistive dans le substrat. Enfin, les selfs $L_1$ et $L_2$ sont intégrables sous forme de lignes microrubans en forme de spirales, et les capacités fixes sous forme de structure interdigitées.

Dans un exemple de réalisation monolitiquement intégré sur arséniure de gallium, il à été utilisé les éléments présentant des caractéristiques rassemblées dans le tableau suivant.

| Transistors ou diodes | 20 | 10 | 21 | 22 | 23 |
|---|---|---|---|---|---|
| Largeur de grille | 300 µm | » | » | » | » |
| Longueur de grille | 1 µ | | | | |
| Tension de seuil | 3,5 V | | | | |
| Capacités | $C_{11}$ | $C_{12}$ | | | |
| Valeurs | 0,2 pF | 0,3 pF | | | |
| Résistances | $R_1$ | $R_2$ | $R_{11}$ | $R_{12}$ | |
| Valeurs | 330 kΩ | 220 kΩ | 50 Ω | 40 Ω | |
| Selfs | $L_1$ | $L_2$ | $L_{11}$ | $L_{12}$ | |
| Valeurs | 1,5 nH | 1 nH | 0,5 nH | 5 nH | |

Tension d'alimentation continue $V_c = 6,5^v$
Fréquence de fontionnement    F = 12 GHz

## Revendications

1. Circuit formant une capacité linéairement variable en fonction de la température caractérisé en ce que cette capacité est formée par la capacité $C_v$ électrode d'entrée-canal d'un élément actif du type à diode Schottky dit élément actif de compensation dont l'électrode de sortie, ou les électrodes de sortie court-circuitées, est/sont soumise(s) à une tension de commande $V_v$ variable en fonction de la température, cette tension de commande $V_v$ étant fixée d'une part par rapport à la masse au travers d'une première résistance $R_1$ et d'autre part par rapport à l'alimentation continue $V_c$ au travers de N éléments actifs de type Schottky montés en diodes et en série, dont la première électrode d'entrée est connectée à l'alimentation continue $V_c$ à travers une seconde résistance $R_2$, et dont la dernière électrode de sortie est connectée à la sortie de l'élément actif de compensation, le nombre N d'éléments actifs étant choisi en tenant compte du fait que la tension de seuil des éléments actifs de type Schottky diminuant linéairement lorsque la température augmente, alors la tension $V_v$ appliquée à la sortie de l'élément actif de compensation augmente linéairement lorsque la température augmente et proportionnellement au nombre N, permettant de ce fait une augmentation linéaire de la capacité $C_v$ électrode d'entrée-canal de cet élément de compensation.

2. Circuit selon la revendication 1, caractérisé en ce qu'il est réalisé à l'aide de transistors à effet de champ de type Schottky.

3. Circuit selon la revendication 1, caractérisé en ce qu'il est réalisé à l'aide de diodes Schottky.

4. Circuit selon l'une des revendications 1, 2 ou 3, caractérisé en ce qu'il est intégré sur un substrat en arséniure de gallium.

5. Circuit oscillateur hyperfréquences stabilisé en fréquence en fonction de la température, comprenant un transistor à effet de champ à diode Schottky sur la grille duquel est appliqué un circuit destiné à déterminer la fréquence d'oscillation incluant une capacité variable en fonction de la température, caractérisé en ce que le circuit destiné à déterminer la fréquence d'oscillation est constitué d'une première self $L_1$ reliée d'une part à la masse et d'autre part à la grille du transistor oscillant, et d'une seconde self $L_2$ reliée d'une part à la grille du transistor oscillant et d'autre part à l'électrode d'entrée de l'élément actif de compensation d'un circuit réalisé conformément à l'une des revendications 1 à 4 formant la capacité variable en fonction de la température.

6. Circuit selon la revendication 5, caractérisé en ce qu'il est monolitiquement intégré sur un substrat en arséniure de gallium.

## Patentansprüche

1. Schaltungsanordnung, die eine Kapazität bildet, die gegenüber der Temperatur linear veränderlich ist, dadurch gekennzeichnet, dass diese Kapazität durch die Eingangselektrodenkanalkapazität $C_v$ eines aktiven Elementes vom Schottky-Diodentyp gebildet wird, dessen kurzgeschlossene Ausgangselektrode(n) mit einer temperaturveränderlichen Steuerspannung $V_v$ verbunden ist bzw. sind, wobei diese Steuerspannung $V_v$ einerseits gegenüber Masse über einen ersten Widerstand $R_1$ und andererseits gegenüber der Gleichstromspeisung $V_c$ über N aktive reihengeschaltete und Dioden-verbundene Elemente vom Schottky-Typ, deren erste Eingangselektrode über einen zweiten Widerstand $R_2$ mit der Gleichstromspeisung $V_c$ verbunden ist, gebildet wird und wobei die letzte Ausgangselektrode mit dem Ausgang des aktiven Ausgleichselementes verbunden ist, wobei die Anzahl N der aktiven Elemente unter Berücksichtigung der Tatsache gewählt worden ist, dass die Schwellenspannung der aktiven Elemente vom Schottky-Typ linear abnimmt wenn die Temperatur ansteigt, während die zugeführte Spannung $V_v$ am Ausgang des aktiven Ausgleichselementes linear zunimmt wenn die Temperatur ansteigt und proportional zu der Anzahl N, wodurch eine lineare Erhöhung der Elektrodenkapazität $C_v$ des Eingangskanals dieses Ausgleichselementes entsteht.

2. Schaltungsanordnung nach Anspruch 1, dadurch gekennzeichnet, dass diese mit Hilfe von Feldeffekttransistoren vom Schottky-Typ verwirklicht worden ist.

3. Schaltungsanordnung nach Anspruch 1, dadurch gekennzeichnet, dass diese mit Hilfe von Schottky-Dioden verwirklicht worden ist.

4. Schaltungsanordnung nach Anspruch 1, 2 oder 3, dadurch gekennzeichnet, dass diese auf einem Gallium-Arsenid-Substrat integriert ist.

5. Höchstfrequenzoszillator, der gegenüber der Temperatur frequenzstabilisiert ist mit einem Feldeffekttransistor vom Schottky-Diodentyp, dessen Gate-Elektrode mit einer Schaltungsanordnung verbunden ist, die dazu bestimmt ist, die Schwingungsfrequenz zu bestimmen und die mit einer temperaturveränderlichen Kapazität versehen ist, dadurch gekennzeichnet, dass die Schaltungsanordnung zur Bestimmung der Schwingungsfrequenz aus einer Selbstinduktivität $L_1$ besteht, die einerseits mit Masse und andererseits mit der Gate-Elektrode des Oszillatortransistors verbunden ist, sowie aus einer zweiten Selbstinduktivität $L_2$, die einerseits mit der Gate-Elektrode des Oszillatortransistors und andererseits mit der Eingangselektrode des aktiven Ausgleichselementes einer Schaltungsanordnung nach einem der Ansprüche 1 bis 4 verbunden ist, welche die temperaturabhängige Kapazität bildet.

6. Schaltungsanordnung nach Anspruch 5, dadurch gekennzeichnet, dass diese monolitisch auf einem Gallium-Arsenid-Substrat integriert ist.

## Claims

1. A circuit forming a capacitance which is linearly variable versus temperature characterized in that this capacitance is formed by the input-electrode channel capacitance $C_v$ of an active element of the Schottky diode type referred to as active compensation element whose output electrode, or the shortcircuited output electrodes is/are subjected to a temperature-variable control voltage $V_v$, this control voltage $V_v$ being derived via a first resistor R, on the one hand being connected to ground and on the other hand to the d.c. supply voltage $V_c$ via N active diode-connected and series-arranged elements of the Schottky type whose first input electrode is connected to the d.c. supply voltage $V_c$ via a second resistor $R_2$ and whose last output electrode is connected to the output of the active compensation element, the number N of active elements being chosen on the basis of the fact with the threshold voltage of the Schottky-type active elements decreasing linearly with increasing temperature, the voltage $V_v$ applied to the output of the active compensation element increases linearly with increasing temperature and proportionally to the number N thus permitting a linear increase of the input-electrode channel capacitance $C_v$ of this compensation element.

2. A circuit as claimed in Claim 1, characterized in that it is formed by Schottky field effect transistors.

3. A circuit as claimed in Claim 1, characterized in that it is formed by Schottky diodes.

4. A circuit as claimed in any of the Claims 1, 2 or 3, characterized in that it is integrated on a gallium-arsenide substrate.

5. A hyper frequency oscillator circuit whose frequency is stabilized versus temperature, comprising a Schottky diode-arranged field effect transistor, the gate of this field effect transistor being connected to a circuit, which determines the oscillating frequency and including a capacitance which is variable versus temperature, characterized in that the circuit for determining the oscillating frequency comprises a first inductance $L_1$ at one end being coupled to ground and at the other end to the gate of the oscillating transistor and a second inductance $L_2$ at one end being coupled to the gate of the oscillating transistor and at the other end to the input electrode of an active compensating element of a circuit realized as claimed in one of the Claims 1 to 4 which forms the temperature-variable capacitance.

6. A circuit as claimed in Claim 5, characterized in that it is monolythically integrated on a gallium-arsenide substrate.

FIG.1

FIG.2

FIG.3